# EUROPEAN PATENT APPLICATION

(11) **EP 1 339 270 A2**
(43) Date of publication of application: **27.08.2003**
(21) Application number: 03251090.1
(22) Date of filing: 24.02.2003
(51) Int. Cl.: H05K 3/38, B32B 15/08

(54) **Method of manufacturing metal clad laminate for printed circuit board**

(30) Priority: 25.02.2002 KR 2002009827
(71) Applicant: SMART Electronics, Inc., Ulju-Gun, Ulsan-City (KR)
(72) Inventor: Yoo, Byuong Kuk, Boopyung-Gu, Incheon-City (KR); Baik, Eun Song, Chonan-City, Chungnam (KR); Song, Jong Seok, Seoul-City (KR); Cho, Rae Ook, Pusan-City (KR)
(74) Representative: Dempster, Benjamin John Naftel

(57) **Abstract**

The present invention relates to a method of manufacturing a metal clad laminate for printed circuit board, characterized by direct adhesion of a conductive metal foil without use of a thermosetting resin having low melting points, an adherent film or an adhesive. The method includes forming fine protrusions on at least one surface of a fluorine-based resin insulation layer, roughening one surface of a conductive metal foil, laminating the fluorine-based resin insulation layer having fine protrusions on the roughened metal foil so that the roughened surface of the metal foil and the protrusion-formed surface of the insulation layer face each other to form a laminated body, and compressing the laminated body under vacuum, pressure and heat. The method of manufacturing the metal clad laminate by directly adhering the conductive metal foil with a single dielectric structure has advantages in terms of lower manufacturing costs compared to conventional dual dielectric structures, and very stable operation of the metal clad laminate in high frequency regions due to minimized variations of electrical and mechanical properties. Thus, the present method is effective in manufacturing the printed circuit board usable in the high frequency regions.

## Description

The present invention relates to a method of manufacturing a metal clad laminate for use in printed circuit boards, characterized in that a fluorine-based resin among various heat resistant insulation resins, such as polytetrafluoroethylene (PTFE) and PTFE-impregnated glass cloth, having low dielectric dissipation factor in high frequency regions is laminated at a top surface and a bottom surface thereof with a conductive metal foil made of copper or aluminium.

As well known to those skilled in the art, a metal clad laminate using an epoxy resin is conventionally manufactured by impregnating the epoxy resin into a glass cloth, drying the impregnated cloth to remove organic solvents from the cloth, producing a prepreg for use in conversion to a semi-cured state to cure the resin, and laminating a conductive metal foil on the cured resin.

In addition, the metal clad laminate may be manufactured by use of a fluorine-based resin as a thermoplastic resin. However, the fluorine-based resin has a disadvantage of non-adhesiveness with other materials attributable to very low surface energy. Thus, in a case of the fluorine-based resin, the conductive metal foil is not directly adhered to the resin, whereby the above method of adhering the conductive metal foil to the fluorine-based resin is not employed. Typically, a thermosetting resin having low melting point, an adherent film or an adhesive is additionally interposed into the conductive metal foil and a heat resistant fluorine-based insulating resin including polytetrafluoroethylene and polytetrafluoroethylene-impregnated glass cloth, to form a laminated body. Then, processes of compressing and curing the laminated body are performed under heat and pressure. However, the above mentioned method suffers from drastically degraded properties of the insulation resin due to use of the thermosetting film having low melting point or adhesive of the laminated body. Thus, there are required methods of directly adhering the conductive metal foil with the fluorine-based resin in which no thermosetting resin, adherent film or adhesive is applied therebetween.

On the other hand, as frequencies increase, many problems are caused upon signal transfer. In order to increase transfer rates with decreasing noise, variations in materials, wiring and circuiting techniques are used. In cases where the materials having low dielectric constants are used, when signals are transferred along wires formed on a board, transfer rates may be increased in inverse proportion to the square root of the dielectric constant, and noise may be decreased. Moreover, a material having low dielectric constant is used to reduce undesirable capacitance generated between neighbouring circuits. Since high-speed digital circuits or amplification circuits in microwave transferring-receiving circuits handle very weak high-speed signals, materials having low dielectric dissipation factor should be used. As the frequencies increase, transfer loss is varied with the dielectric dissipation factor. As in conventional laminating methods of the fluorine-based resin, when an adherent film with high dielectric dissipation factor is directly laminated on a dielectric material with low dielectric dissipation factor, transfer loss becomes high. Accordingly, there is further required a method of manufacturing the metal clad laminate for printed circuit boards having a single structure and exhibiting inherent properties of the dielectric material without the use of an adherent film.

Leading to the present invention, the intensive and thorough research upon lamination are optimized, the desired metal clad laminate is manufactured.

Accordingly, it is an aspect of the present invention to provide a method of directly laminating a conductive metal foil on a heat resistant insulation resin, in particular, a fluorine-based resin, without use of a thermosetting resin, an adherent film or an adhesive.

Additional aspects and advantages of the invention will be set forth in part in the description which follows and, in part, will be obvious from the description, or may be learned by practice of the invention.

The foregoing and other aspects of the present invention are achieved by providing a method of manufacturing a metal clad laminate for printed circuit boards, including (a) forming fine protrusions on at least one surface of a fluorine-based resin insulation layer, (b) roughening one surface of a conductive metal foil, (c) laminating the fluorine-based resin insulation layer having fine protrusions on the roughened metal foil so that the roughened surface of the metal foil and the protrusion-formed surface of the insulation layer face each other, to form a laminated body, and (d) compressing the laminated body under vacuum, pressure and heat.

In addition, the method further comprises sequentially laminating, on a surface of the fluorine-based resin insulation layer not having fine protrusions in the laminated body before the (d) operation is performed, at least one fluorine-based resin insulation layer not subjected to the (a) operation, a second fluorine-based resin insulation layer subjected to the (a) operation and a second conductive metal foil subjected to the (b) operation, in which the roughened surface of the second metal foil subjected to the (b) operation and the protrusion-formed surface of the second insulation layer subjected to the (a) operation face each other.

These and other aspects and advantages of the invention will become apparent and more readily appreciated from the following description of the preferred embodiments, taken in conjunction with the accompanying drawings of which:
FIG. 1 is an electron microphotograph illustrating a polytetrafluoroethylene (PTFE) resin which is not subjected to surface treatment;
FIG. 2 is an electron microphotograph illustrating a polytetrafluoroethylene (PTFE) resin having protrusions formed thereon which is subjected to surface treatment with use of 20 sccm of normal atmosphere to increase the surface energy thereof;
FIG. 3 is an electron microphotograph illustrating a polytetrafluoroethylene (PTFE) resin having protrusions formed thereon which is subjected to surface treatment without use of normal atmosphere to increase the surface energy thereof;
FIG. 4 is an electron microphotograph illustrating a polytetrafluoroethylene (PTFE) resin having protrusions formed thereon which is subjected to surface treatment with use of 12 sccm of normal atmosphere to increase the surface energy thereof;
FIG. 5 is a sectional view illustrating the resin having one surface with protrusions and the other surface without protrusions, according to the present invention;
FIG. 6 is a view illustrating a sequentially laminated structure of a printed circuit board including a metal foil, insulation resin layers and another metal foil, according to the present invention; and
FIG. 7 is a view illustrating a process of compressing the laminated structure shown in FIG. 6 by use of hot presses in a vacuum chamber; and
FIG. 8 is a sectional view illustrating a metal clad laminate compressed by the process of FIG. 7.

Reference will now be made in detail to the present preferred embodiments of the present invention, examples of which are illustrated in the accompanying drawings, wherein like reference numerals refer to like elements throughout.

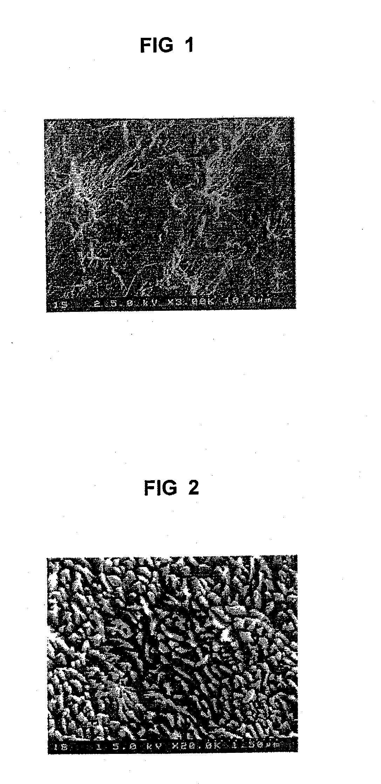

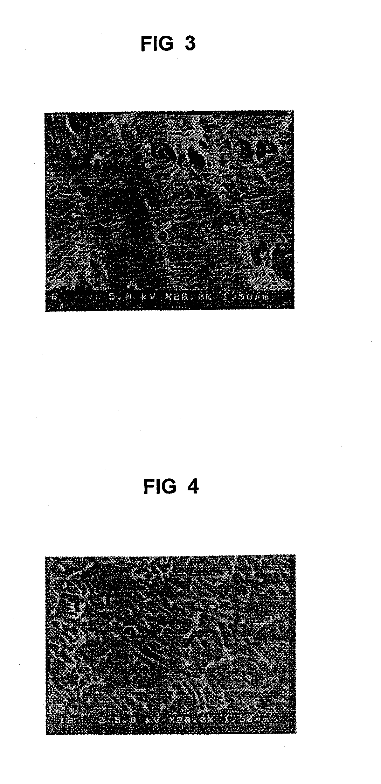

FIG. 1 illustrates polytetrafluoroethylene (PTFE) which is not subjected to surface treatment, and FIGs. 2 through 4 illustrate polytetrafluoroethylenes (PTFE) having protrusions formed thereon, each of which is subjected to surface treatment under different conditions. Since a fluorine-based resin insulation layer having non-oiliness and non-adhesiveness is not easily adhered with other materials, a surface of the resin which is adhered with a conductive metal foil is subjected to surface treatment to cause the inherently non-adhesive surface of the resin to gain adhesiveness, and then is heated and compressed under vacuum. Thereby, surface energy of the resin is increased to easily perform adhesion. The surface of the resin is substantially formed with fine protrusions. Polytetrafluoroethylene before being subjected to surface treatment, as shown in FIG. 1, is formed with protrusions as in FIG. 2, to easily adhere with other materials.

The fine protrusions formed on the insulation layer have an average diameter of 0.01-2 mm and an average aspect ratio of 1:20 or less. If the average diameter is less than 0.01 mm, adhesive strength with the roughened surface of the metal foil is decreased. Meanwhile, if the average diameter exceeds 2 mm, smoothness of the resin surface is inferior and also adhesive strength with the roughened surface of the metal foil is decreased. The average diameter and the aspect ratio of the fine protrusions are suitably adjusted by controlling the atmosphere and beam power used in the protrusion-forming process.
The fluorine-based resin usable in the present invention is selected from the group consisting of polytetrafluoroethylene (PTFE), polytetrafluoroethylene-impregnated glass cloth, polychlorotrifluoroethylene (PCTFE), tetrafluoroethylene-hexafluoropropylene copolymer (FEP), polyvinylidene fluoride (PVDF), polyvinyl fluoride (PVF), ethylenetetrafluoroethylene (ETFE), perfluoroalkoxy (PFA), chlorotrifluoroethylene (CTFE), and ethylenechlorotrifluoroethylene (ECTFE). The fluorine-based resin is not limited in the above examples, and all fluorine resins containing fluorine may be used.

At least two of the insulation layers each having a thickness of 0.05-0.508 mm are laminated so that the metal clad laminate has a thickness of 0.127-5.08 mm.

The conductive metal foil is made of copper, aluminium or alloys thereof.

Adhesion between the fluorine-based resin and the metal foil is based on the following mechanism: a laminated body of the fluorine-based resin having fine protrusions and the metal foil is heated to approximately a temperature region of a melting point of the fluorine-based resin, after which the resin is compressed to the roughened metal foil by pressure of a hot press and then cooled. Thereby, the metal foil and the resin are physically interlocked due to anchoring effect therebetween. That is, in order to prepare the fluorine-based insulation resin having fine protrusions and the conductive metal foil as a metal clad laminate, compression by a hot press system is performed.

The laminated body is heated, compressed and cooled under conditions of a maximal temperature of the hot press ranging from a glass transition temperature of the fluorine-based resin to a temperature 20% more than a melting point of the fluorine-based resin, a hot press pressure of 10-90 kg/cm², a vacuum level ranging from 1 mTorr to 500 Torr, and a period of time of 3 hours.

The maximal temperature of the hot press is controlled in the range of from the glass transition temperature of the fluorine-based resin to the temperature 20% higher than the melting point of the resin. This temperature is sufficient to generate the anchoring effect between the metal foil and the resin and to adhere the insulation resins. The fluorine-based resin is hardly heat-deteriorated at temperatures lower than the melting point thereof. However, at temperatures higher than the melting point, the resin is decreased in polymerization degree and in molecular weight and the specific gravity is increased. For example, polytetrafluoroethylene as the fluorine-based resin is little heat-deteriorated at temperatures lower than the melting point. However, the above resin has decreased polymerization degree at temperatures higher than the melting point. At much higher temperatures than the melting point of the polymer, specific gravity is increased and molecular weight is decreased. Further, at 400 °C or higher, the above phenomena become severe and the material rapidly deteriorates. Thus, the fluorine-based resin should be subjected to compression by hot press in the temperature range 20% higher than the melting point thereof. Then, mechanical properties desired in the present invention are obtained.

In addition, the fluorine-based resin has higher melting point compared to other polymers. Thus, when a hot press process is performed under normal atmosphere, the metal foil is rapidly oxidized. The metal clad lamination is generally performed at 100-250 °C. When the metal clad lamination is performed outside of the above temperature ranges, metal, in particular, copper is rapidly oxidized and corroded upon compression under normal atmosphere. Thus, it is difficult to use the copper as a board. In order to prevent oxidation of the metal and foaming in the insulation resin, heating and compressing operations are performed by use of a vacuum unit capable of maintaining vacuum of several millitorr to several hundreds of torr, and preferably 1 mTorr to 500 Torr. The period of time required to heat and compress the laminated body and then to cool the compressed body is 3 hours or shorter.

Hereinafter, a detailed description will be given of an embodiment of the present invention, with reference to the attached drawings.

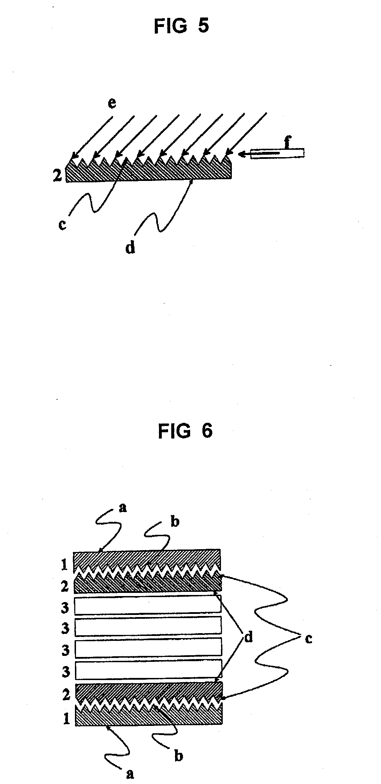

As shown in FIGs. 5 and 6, a resin 2 having fine protrusions (c) formed by controls of atmospheres (f) and beam powers (e), and a metal foil 1 having a roughened surface (b) (e.g., roughened matte surface of an electrolytic copper foil) are laminated so that the protrusion-formed surface and the roughened surface face each other. A plurality of the same type of resins 3 not having fine protrusions are layered to a desired thickness on the resin 2. Then, another resin 2 having fine protrusions (c) and another metal foil 1 having a roughened surface (b) (e.g., roughened matte surface of an electrolytic copper foil) are sequentially laminated on the resin 3 so that the protrusion-formed surface and the roughened surface face each other. A laminated body having a structure of metal foil 1/insulation resins 2 and 3/metal foil 1 is compressed under heat, pressure and vacuum.

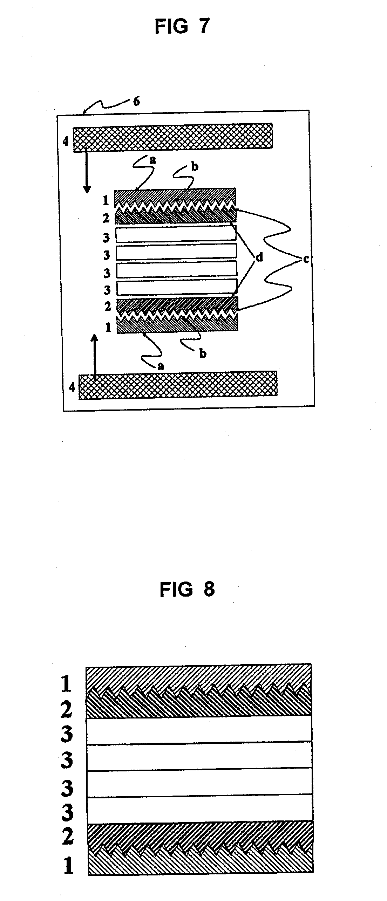

FIG. 7 illustrates a process of compressing the laminated body. As shown in FIG. 7, since a thermosetting resin or an adhesive is not additionally used, compression temperature reaches the melting point of the fluorine-based resin as a thermoplastic resin. Thereby, fine protrusions (c) of the resin 2 are compressed to the roughened surface (b) of the metal foil 1 by pressure of hot presses 4 and then cooled in a vacuum unit 6. Then, the metal foil 1 and the insulation resin 2 are physically strongly interlocked due to the anchoring effect therebetween. The desired thickness of the board is controlled by the plurality of the laminated insulation resin layers 3 which are not subjected to surface treatment. As such, conditions of heat, pressure and vacuum upon compression depend on types of polymer when the polymer is directly bonded to the metal foil without use of the thermosetting resin or the adhesive. The maximal temperature of the hot presses ranges from the glass transition temperature of the fluorine-based resin to the temperature 20% higher than the melting point of the insulation resin. The pressure of the hot press is in the range of 10 to 90 kg/cm². The laminated body is compressed under heat, pressure and vacuum, to obtain the metal clad laminate for printed circuit board as shown in FIG. 8.

As the fluorine-based resin, polytetrafluoroethylene-impregnated glass cloth has a dielectric constant of 2.5, and a dielectric thickness of 0.762 mm. When the electrolytic copper foil is 1 oz thick, exfoliation strength of the copper foil is found to be 2.1 kgf/cm according to USA IPC Standard IPC-TM-650, 2.4.8 method.

Table 1, below, shows the tested results of 1 oz thick electrolytic copper foil and 0.762 mm thick resin adhered together, while the dielectric constants are varied.

**TABLE 1**

| Properties | | Unit | Condition | Method | SPGE 230 | SPGE 250 | SPGE 270 |
|---|---|---|---|---|---|---|---|
| Surface Resist. | | U | C-96/25/90 +C-96/35/90 | IPC-TM-650, 2.5.17.1 | 1 × 10¹⁵ | 1 × 10¹⁵ | 1 x 10¹⁵ |
| Volume Resist | | U cm | C-96/25/90 +C-96/35/90 | IPC-TM-650, 2.5.17.1 | 5 × 10¹⁵ | 5 × 10¹⁵ | 5 × 10¹⁵ |
| Specific Gravity | | g/cm³ | A | ASTM D-792 | 2.1 | 2.1 | 2.1 |
| Dielect. Const. | 1MHz | | C-96/20/65 | IPC-TM-650, 2.5.5.3 | 2.3 | 2.5 | 2.7 |
| | 1GHz | | | | 2.3 | 2.5 | 2.7 |
| | 3GHz | | | IPC-TM-650, 2.5.5.5 | 2.3 | 2.5 | 2.7 |
| | 10GHz | | | | 2.3 | 2.5 | 2.7 |
| Dielect. Dissip. Factor | 1MHz | | C-96/20/65 | IPC-TM-650, 2.5.5.3 | 0.0002 | 0.0003 | 0.0004 |
| | 1GHz | | | | 0.0003 | 0.0004 | 0.0005 |
| | 3GHz | | | IPC-TM-650, 2.5.5.5 | 0.0005 | 0.0007 | 0.0009 |
| | 10GHz | | | | 0.0014 | 0.0017 | 0.0021 |
| Heat Conductivity | | W/m/°K | 25°C | ASTM E-1225 | 0.29 | 0.29 | 0.29 |
| Arc Resistance | | Sec | C-48/23 | ASTM D-495 | >180 | >180 | >180 |
| Flammability | | - | A(E-1/150) | IPC-TM-650, 2.3.10 | V-O | V-O | V-O |
| Water Absorption | | % | E-24/105 +D/24/23 | IPC-TM-650, 2.6.2.1 | 0.04 | 0.04 | 0.04 |
| Exfoliation Strength (Cu foil 0.035mm) | | Kgf/cm | A | IPC-TM-650, 2.4.8 | 2.1 | 2.1 | 2.1 |

### Example 1

A polytetrafluoroethylene-impregnated glass cloth having a thickness of 0.127 mm was subjected to surface treatment by use of 20 sccm of certain atmosphere at room temperature as shown in FIG. 5, to form fine protrusions having an average diameter of 0.1 mm and an average roughness of 500 nm as shown in FIG. 2. This process is based on a dry method and does not require an additional cleaning operation.

0.127 mm thick polytetrafluoroethylene-impregnated glass cloth 2 having protrusions formed on a surface thereof was laminated on a roughened electrolytic copper foil 1 having a thickness of 1 oz so that the protrusion-formed surface of the glass cloth 2 and the roughened surface of the copper foil 1 faced each other, to form an electrode.

On the other side of the 0.127 mm thick polytetrafluoroethylene-impregnated glass cloth 2 not having protrusions, that is, a surface not having protrusions, four polytetrafluoroethylene-impregnated glass cloths 3 were stacked, each of which had a thickness of 0.127 mm and was not subjected to surface treatment.

In order to form an opposite electrode, 1 oz thick roughened electrolytic copper foil 1 was laminated on 0.127 mm thick polytetrafluoroethylene-impregnated glass cloth 2 having fine protrusions formed on a surface thereof so that the protrusion-formed surface of the glass cloth 2 and the roughened surface of the copper foil 1 faced each other as the same manner as in the above electrode forming process. Then, thusly formed electrode layer was superimposed on the stacked four layers.

The laminated dielectric body (thickness 0.762 mm) was compressed by hot presses 4 under vacuum of 10 Torr, to manufacture a metal clad laminate. A maximal temperature of the hot presses reached a melting point of the polytetrafluoroethylene. In addition, the pressure of the hot presses 4 was 40 kg/cm², and heating and cooling operations were performed for 3 hours.

In the case of dielectric constant of 2.3, dielectric thickness of 0.762 mm and an electrolytic copper foil being 1 oz thick, exfoliation strength of the copper foil was measured according to USA IPC Standard IPC-TM-650, 2.4.8 method, and found to be 2.1 kgf/cm. A dielectric dissipation factor was found to be 0.0014 at 10 GHz, measured by IPC-TM-650, 2.5.5.5 method.

### Example 2

A metal clad laminate was manufactured in the same manner as in the above example 1. In the case of dielectric constant of 2.5, dielectric thickness of 0.762 mm and the electrolytic copper foil being 1 oz thick, exfoliation strength of the copper foil was measured according to USA IPC Standard IPC-TM-650, 2.4.8 method, and found to be 2.1 kgf/cm. A dielectric dissipation factor was 0.0017 at 10 GHz, measured by IPC-TM-650, 2.5.5.5 method.

### Example 3

A metal clad laminate was manufactured in the same manner as in the above example 1. In the case of dielectric constant of 2.7, dielectric thickness of 0.762 mm and the electrolytic copper foil being 1 oz thick, exfoliation strength of the copper foil was measured according to USA IPC Standard IPC-TM-650, 2.4.8 method, and found to be 2.1 kgf/cm. A dielectric dissipation factor was 0.0021 at 10 GHz, measured by IPC-TM-650, 2.5.5.5 method.

As in the above examples, the metal clad laminate for printed circuit boards manufactured by the method of the present invention is excellent in mechanical properties with low dielectric dissipation factor.

As mentioned above, according to the method of the present invention, a single dielectric structure is directly clad with the conductive metal foil, whereby the insulation resin and the metal foil are adhered together. Thereby, compared to conventional dual dielectric structures, the method of the present invention is advantageous in terms of low manufacturing costs, and exhibiting inherent properties of the dielectric due to minimized variations of electrical and mechanical properties. Thus, a printed circuit board having excellent properties and low dielectric dissipation factor, capable of operating stably in high frequency regions, is manufactured.

Although a few preferred embodiments of the present invention have been shown and described, it would be appreciated by those skilled in the art that changes may be made in these embodiments without departing from the principles and spirit of the invention, the scope of which is defined in the claims and their equivalents.

## Claims

1. A method of manufacturing a metal clad laminate for printed circuit boards, comprising:
(a) forming fine protrusions on at least one surface of a fluorine-based resin insulation layer;
(b) roughening one surface of a conductive metal foil;
(c) laminating the fluorine-based resin insulation layer having fine protrusions on the roughened metal foil so that the roughened surface of the metal foil and the protrusion-formed surface of the insulation layer face each other, to form a laminated body; and
(d) compressing the laminated body under vacuum, pressure and heat.

2. The method as defined in claim 1, further comprising sequentially laminating, on a surface of the fluorine-based resin insulation layer not having fine protrusions in the laminated body before the (d) operation is performed, at least one fluorine-based resin insulation layer not subjected to the (a) operation, a second fluorine-based resin insulation layer subjected to the (a) operation, and a second conductive metal foil subjected to the (b) operation, wherein the roughened surface of the second metal foil subjected to the (b) operation and the protrusion-formed surface of the second insulation layer subjected to the (a) operation face each other.

3. The method as defined in claim 1 or 2, wherein the fine protrusions formed on the insulation layer have an average diameter of 0.01-2 mm and an average aspect ratio of 1:20 or less.

4. The method as defined in claim 1 or 2, wherein the fluorine-based resin is all fluorine resins containing fluorine, comprising polytetrafluoroethylene, polytetrafluoroethylene-impregnated glass cloth, polychlorotrifluoroethylene, tetrafluoroethylene-hexafluoropropylene copolymer, polyvinylidene fluoride, polyvinyl fluoride, ethylenetetrafluoroethylene, perfluoroalkoxy, chlorotrifluoroethylene, and ethylenechlorotrifluoroethylene.

5. The method as defined in claim 1 or 2, wherein at least two of the insulation layers each having a thickness of 0.05-0.508 mm are laminated so that the metal clad laminate has a thickness of 0.127-5.08 mm.

6. The method as defined in claim 1 or 2, wherein the conductive metal foil is made of copper, aluminum or alloys thereof.

7. The method as defined in claim 1 or 2, wherein the (d) operation is performed under conditions of a maximal temperature of a hot press ranging from a glass transition temperature of the fluorine-based resin to a temperature 20% higher than a melting point of the fluorine-based resin, a hot press pressure of 10-90 kg/cm² and a vacuum level ranging from 1 mTorr to 500 Torr, within 3 hours.

8. A method of manufacturing a metal clad laminate for printed circuit boards, comprising:
(a) forming protrusions on at least one surface of a fluorine-based resin insulation layer;
(b) roughening one surface of a conductive metal foil;
(c) laminating the fluorine-based resin insulation layer having protrusions on the roughened metal foil so that the roughened surface of the metal foil and the protrusion-formed surface of the insulation layer face each other, to form a laminated body; and
(d) compressing the laminated body under vacuum, pressure and heat.
